# EUROPEAN PATENT SPECIFICATION

(11) **EP 2 042 267 B1**
(45) Date of publication and mention of the grant of the patent: **05.03.2014**
(21) Application number: 07744696.1
(22) Date of filing: 05.06.2007
(51) Int. Cl.: B24B 37/04, H01L 21/304

(54) **CARRIER FOR DOUBLE-SIDE POLISHING APPARATUS, DOUBLE-SIDE POLISHING APPARATUS USING THE SAME,AND DOUBLE-SIDE POLISHING METHOD**
TRÄGER FÜR DOPPELSEITIGE POLIERVORRICHTUNG UND DEN TRÄGER VERWENDENDE(S)DOPPELSEITIGE POLIERVORRICHTUNG UND VERFAHREN ZUM DOPPELSEITIGEN POLIEREN
SUPPORT POUR DISPOSITIF DE POLISSAGE RECTO VERSO ET DISPOSITIF DE POLISSAGE RECTO VERSO ET PROCÉDÉ DE POLISSAGE RECTO VERSO UTILISANT LE SUPPORT

(30) Priority: 18.07.2006 JP 2006195967
(43) Date of publication of application: 01.04.2009
(73) Proprietor: Shin-Etsu Handotai Co., Ltd., Tokyo (JP)
(72) Inventor: UCHIYAMA, Isao, Nishishirakawa-gun Fukushima 961-8061 (JP)
(74) Representative: Wibbelmann, Jobst
(86) International application number: PCT/JP2007/061339
(87) International publication number: WO 2008/010357

(56) References cited:
- JP-A- 05 004 165
- JP-A- 2003 231 054
- JP-A- 2006 026 760

## Description

### TECHNICAL FIELD

The present invention relates to a carrier for double-side polishing apparatus that holds a semiconductor wafer when polishing the semiconductor wafer in a double-side polishing apparatus as e.g. known from document US-A-2007/0184662.

### BACKGROUND ART

When, e.g., polishing both surfaces of a semiconductor wafer, the semiconductor wafer is held by a carrier in conventional examples. This carrier is formed with a thickness thinner than that of the semiconductor wafer and has a wafer holding hole through which the wafer is held at a predetermined position between an upper turn table and a lower turn table of a double-side polishing apparatus. The semiconductor wafer is inserted into and held in this wafer holding hole, upper and lower surfaces of the semiconductor wafer are sandwiched by polishing jig, e.g., polishing pads provided on opposed surfaces of the upper turn table and the lower turn table, and polishing is carried out while supplying a polishing agent to the polishing target surfaces.

When double-side polishing is carried out in this manner, an outer peripheral portion alone of the semiconductor wafer is excessively polished due to, e.g., concentration of a pressure on the outer peripheral portion of the semiconductor wafer or an influence of viscoelasticity of a polishing slurry or polishing pads, and peripheral sag occurs. There is a problem that this peripheral sag degrades a flatness of the wafer.

As a method for reducing such peripheral sag, there is disclosed a method for performing a secondary double-side polishing step that remedies peripheral sag produced at a primary double-side polishing step (see Japanese Patent Publication (Kokai) No. 2005-158798).

However, this method has a defect that the number of steps is increased when the secondary double-side polishing step that remedies the peripheral sag is performed, and a double-side polishing method that can more readily reduce the peripheral sag has been demanded.

Further, in conventional wafer polishing, dressing of polishing pad surfaces is performed by using, e.g., a ceramic plate in order to obtain stable polishing characteristics. However, in the double-side polishing, not only the wafer as a workpiece but also a carrier is in contact with the polishing pads, an effect of dressing of the polishing pad surfaces does not last long, and there is a problem that dressing of the polishing pad surfaces must be frequently carried out by using, e.g., a ceramic plate.

Furthermore, there is also a problem that a life of the carrier itself is short and a cost is increased.

JP 2006 026760 A discloses a carrier for holding a material to be polished comprising a resin-made frame mounted on the inner edge part thereof, and having one or more holes for holding the material to be polished. The surface of the carrier base material is in part made of a metal which is coated with material, which is the same as the carrier base material or has a higher hardness.

JP 05 004165 A discloses a wafer retaining carrier having a wafer receiving hole which is provided with abrasive agent introduction grooves on its underside extending from an outer side surface to the wafer receiving hole. The upper surface of this wafer retaining carrier is contacted with a pressurizing head, and the carrier is mounted to the head.

US 2007/0184662 A1 discloses a carrier for double-side polishing with stainless steel as a base material, wherein the base material is coated with a coating layer of a material having a hardness higher than that of the base material. In particular, the coated surface of the double-side polishing carrier may have a roughness of 0.3 µm or less.

### DISCLOSURE OF INVENTION

Therefore, in view of the above-explained problems, it is an object of the present invention to provide a carrier for double-side polishing apparatus that enables stably and efficiently producing a high-quality wafer having a high flatness with reduced wafer peripheral sag at a low cost at the time of double-side polishing of the semiconductor wafer, a double-side polishing apparatus using the same, and a double-side polishing method.

To achieve this object, according to the present invention, there is provided a carrier for double-side polishing apparatus which is set between upper and lower turn tables having polishing pads attached thereto and has a holding hole in which a semiconductor wafer sandwiched between the upper and lower turn tables is held at the time of polishing in a double-side polishing apparatus, wherein the material of the carrier is titanium, and surface roughness of the titanium carrier is 0.32 µm or above in terms of Ra.

When the material of the carrier is titanium, since a hardness is higher and abrasion at the time of polishing is smaller than those of a resin, a carrier life can be improved. Furthermore, titanium itself has a small diffusion coefficient in the semiconductor wafer, e.g., silicon, it hardly becomes a problem as an impurity, and a metal impurity having a large diffusion coefficient like Fe is not present in titanium, thereby suppressing contamination of the metal impurity with respect to the semiconductor wafer. Moreover, when such a titanium carrier having surface roughness of 0.32 µm or above in terms of Ra is used, the high-quality wafer having reduced peripheral sag and a high flatness can be stably efficiently produced. Additionally, since dressing of the polishing pads can be performed by using the carrier surface during polishing, a frequency of dressing of the polishing pads using, e.g., ceramic plate can be reduced, thus efficient polishing can be performed.

When the surface roughness of the carrier is 0.32 µm or above in terms of Ra, the high-quality wafer having reduced peripheral sag and a high flatness can be produced.

Moreover, it is preferable that the carrier to have grooves each reaching the holding hole from a carrier outer peripheral side on front and back surfaces thereof.

When the carrier has the grooves each reaching the holding hole from the carrier outer peripheral side on front and back surfaces thereof in this manner, since the polishing liquid is supplied to the semiconductor wafer through the grooves at the time of polishing, a resistance undergone by the wafer outer peripheral portion at the time of polishing can be alleviated, and the peripheral sag can be reduced. Additionally, dressing of the polishing pads can be also performed by the groove during polishing, a frequency of dressing of the polishing pads using, e.g., ceramic plate can be further decreased.

Further, a pattern of the grooves can be a grid-like pattern or a radial pattern.

When the pattern of the grooves is the grid-like pattern or the radial pattern in this manner, the polishing liquid can be easily and assuredly supplied to the semiconductor wafer at the time of polishing.

Furthermore, when a double-side polishing apparatus comprising the carrier for double-side polishing apparatus according to the present invention is provided, since the material of the carrier is titanium, a life can be increased, and contamination of a metal impurity with respect to a semiconductor wafer can be suppressed, thereby producing the high-quality wafer having reduced peripheral sag and a high flatness. Moreover, since dressing of polishing pads can be performed by carrier surfaces during polishing, a frequency of dressing of the polishing pads using, e.g., ceramic plate can be reduced, thus considerably improving an operating rate of the apparatus.

Furthermore, there is provided a double-side polishing method for a semiconductor wafer, comprising: arranging the carrier between upper and lower turn tables holding the semiconductor wafer in a holding hole formed in the carrier; and sandwiching the semiconductor wafer between the upper and lower turn tables to perform double-side polishing.

When the semiconductor wafer is held in the holding hole of the carrier for double-side polishing apparatus and sandwiched between the upper and lower turn tables to perform double-side polishing in this manner, a life of the carrier is increased, and the high-quality wafer having reduced contamination due to a metal impurity, decreased peripheral sag and a high flatness can be produced. Moreover, dressing of the polishing pads using the carrier surfaces can be carried out during polishing. Therefore, a frequency of dressing of the polishing pads using, e.g., ceramic plate can be reduced, a cost can be decreased, and the semiconductor wafer can be efficiently subjected to double-side polishing.

As explained above, according to the present invention, since titanium is adopted as the material, the carrier for double-side polishing apparatus that has an improved life and hardly occurs contamination due to a metal impurity can be provided, and the high-quality wafer having reduced contamination due to the metal impurity, and decreased peripheral sag, and a high flatness can be stably efficiently produced by using this carrier. Moreover, since dressing of the polishing pads can be performed by using the carrier surfaces during polishing, a frequency of dressing of the polishing pads using, e.g., a ceramic plate can be reduced. Therefore, a cost can be reduced, and the semiconductor wafer can be efficiently subjected to double-side polishing.

### BRIEF DESCRIPTION OF DRAWINGS

FIG. 1 is a vertical cross-sectional view showing an example of a double-side polishing apparatus including a carrier for double-side apparatus according to the present invention;
FIG. 2 is an internal structural view of the double-side polishing apparatus as seen from a plane;
FIG. 3 is a schematic view showing a measurement position for a peripheral sag amount;
FIG. 4 shows measurement results of experiments;
FIG. 5 shows measurement results of experiments;
FIGS. 6 show an example of a pattern of grooves on front and back surfaces of the carrier for double-side polishing apparatus according to the present invention, (a) grid-like pattern, (b) radial pattern;
FIG. 7 shows measurement results of Examples 1 and 2 and Comparative Examples 1 and 2;
FIG. 8 shows measurement results of Examples 3 to 7; and
FIG. 9 shows measurement results of Example 8 and Comparative Example 3.

### BEST MODE(S) FOR CARRYING OUT THE INVENTION

An embodiment according to the present invention will now be explained hereinafter.

As a conventional carrier for double-side polishing apparatus, there is one formed of a metal, e.g., stainless or one having ceramic abrasive grains deposited on a surface of a metal plate, for example. However, when such carriers are used, an outer peripheral portion alone of a held semiconductor wafer is excessively polished at the time of polishing to cause peripheral sag, or deposited abrasive grains fall off to produce scratches on a wafer surface, resulting in a problem that a quality of the semiconductor wafer is reduced.

Further, in double-side polishing, there is a problem that an effect of dressing of polishing pad surfaces does not last long and a ceramic plate or the like must be frequently used to perform dressing of the polishing pad surfaces.

Thus, as a result of keenly conducting experiments, the present inventor has found that a carrier for double-side polishing apparatus in which the material of the carrier is titanium and surface roughness of the titanium carrier is 0.32 µm or above in terms of Ra can solve the above-explained problem, thereby bringing the present invention to completion.

That is, when such a carrier for double-side polishing apparatus is used to perform double-side polishing, a high-quality wafer having reduced peripheral sag and a high flatness can be produced. Furthermore, since dressing of the polishing pads can be performed by using carrier surfaces during polishing, a frequency of dressing of the polishing pads using, e.g., ceramic plate can be reduced, and polishing can be efficiently carried out. Moreover, this carrier has a structure where each carrier surface itself is roughened without depositing abrasive grains, the abrasive grains do not fall off to produce scratches on the wafer surfaces. Additionally, since titanium is adopted as the material, a life becomes long, and contamination of, e.g., iron that affects a wafer quality does not occur.

An embodiment according to the present invention will now be explained hereinafter with reference to appended drawings.

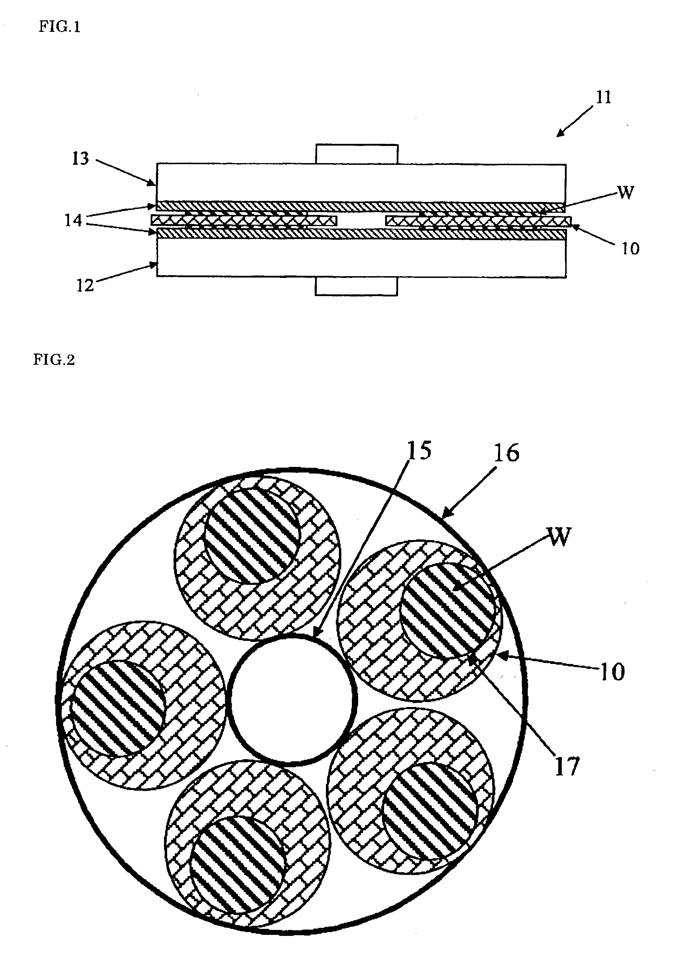

Here, FIG. 1 is a vertical cross-sectional view showing an example of a double-side polishing apparatus including a double-side polishing apparatus according to the present invention, and FIG. 2 is an internal structural view of the double-side polishing apparatus as seen from a plane.

The present invention relates to an improvement in a carrier that holds a semiconductor wafer in a double-side polishing apparatus that simultaneously polishes both surfaces of the semiconductor wafer, and an outline of the double-side polishing apparatus will be first explained with reference to FIGS. 1 and 2.

A double-side polishing apparatus 11 provided with a carrier 10 for double-side polishing apparatus includes a lower turn table 12 and an upper turn table 13 vertically provided to face each other, and polishing pads 14 are attached to opposed surfaces sides of the respective turn tables 12 and 13. Further, a sun gear 15 is provided at a central portion between the upper turntable 13 and the lower turntable 12, and an internal gear 16 is provided at a rim portion. A semiconductor wafer W is held in a holding hole 17 of the carrier 10 and sandwiched between the upper turntable 13 and the lower turn table 12.

Outer peripheral teeth of each carrier 10 mesh with respective tooth portions of the sun gear 15 and the internal gear 16, and each carrier 10 rotates around the sun gear 15 while rotating on its axis when the upper turn table 13 and the lower turn table 12 are rotated by a non-illustrated driving source. At this time, each semiconductor wafer W is held in the holding hole 17 of the carrier 10, and both surfaces thereof are simultaneously polished by the upper and lower polishing pads 14. At the time of polishing, a polishing liquid is supplied from a non-illustrated nozzle.

It is to be noted that each carrier holds one wafer to perform polishing in FIG. 2, but carriers each having a number of holding holes may be used and a number of wafers may be held in each carrier to perform polishing.

The carrier 10 for double-side polishing apparatus according to the present invention set in the double-side polishing apparatus 11 will now be explained hereinafter.

The material of the carrier 10 according to the present invention is titanium, and this material has a higher hardness than that a SUS material coated with resin and does not have an impurity with a large diffusion coefficient like Fe or Ni contained therein. Therefore, scratches or damages can be reduced to increase a carrier life, and a cost can be reduced. Furthermore, contamination of a metal that becomes a problem of the semiconductor wafer W can be suppressed.

A hardness of SUS as a conventional carrier material is 420 Hv, and a hardness of Ti as the material of the carrier 10 according to the present invention is 220 Hv. Therefore, it has been conventionally considered that Ti has the hardness lower than that of SUS and cannot be used as a material of the carrier. However, as explained above, a carrier having the exposed SUS material causes occurrence of crucial metal contamination with respect to the semiconductor wafer W, and the SUS material must be actually coated with a resin in order to suppress the metal contamination. Therefore, each surface of the carrier 10 according to the present invention is titanium, as its material is harder than each surface of the conventional carrier coated with a resin. Therefore, its life becomes long.

Moreover, the carrier 10 according to the present invention is featured in that its surface roughness is 0.32 µm or above in terms of Ra. As a result of conducting the following experiment, the present inventor has discovered that the surface roughness of the carrier must be 0.32 µm or above in terms of Ra in order to obtain a wafer having reduced peripheral sag.

### (Experiment)

As the carrier for double-side polishing apparatus, a number of carriers which are formed of titanium and have different surface roughness degrees obtained by roughening front and back surfaces thereof by diamond pellets having different sizes were prepared.

The surface roughness of each carrier surface was measured by using Surf Test SJ-201P manufactured by Mitutoyo, and evaluation was carried out based on JIS B0601-1994.

Each of the carriers was set in a double-side polishing apparatus, dressing of polishing pads was performed, and then double-side polishing of each silicon wafer having a diameter of 300 mm was performed. That is, the etched silicon wafer was set in each of five titanium carriers each having one holding hole, an upper turn table was rotated in a clockwise direction whilst a lower turn table was rotated in a counterclockwise direction with a number of revolutions of 20 rpm and a load of 250 g/cm², and an alkaline solution containing colloidal silica was used as a polishing liquid to perform polishing.

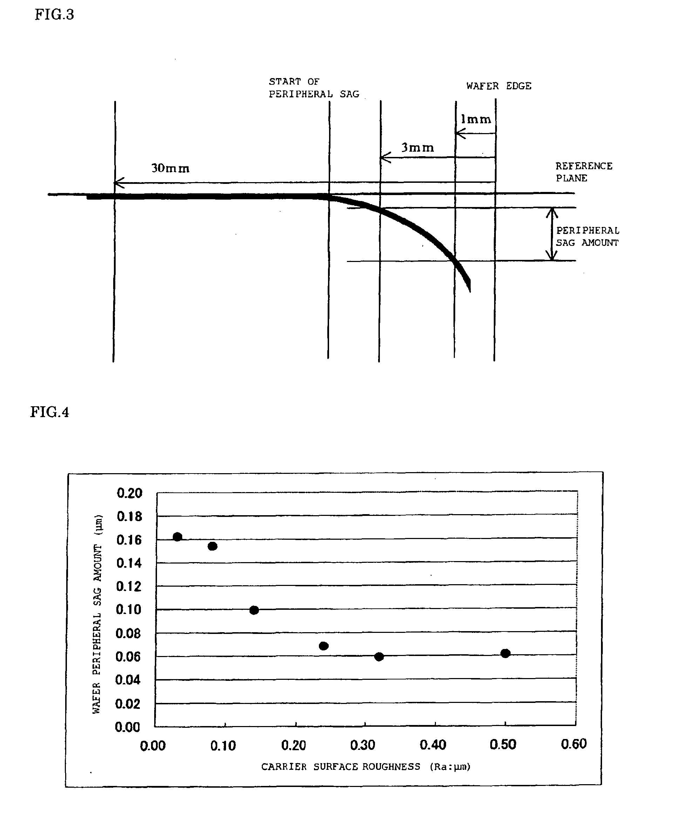

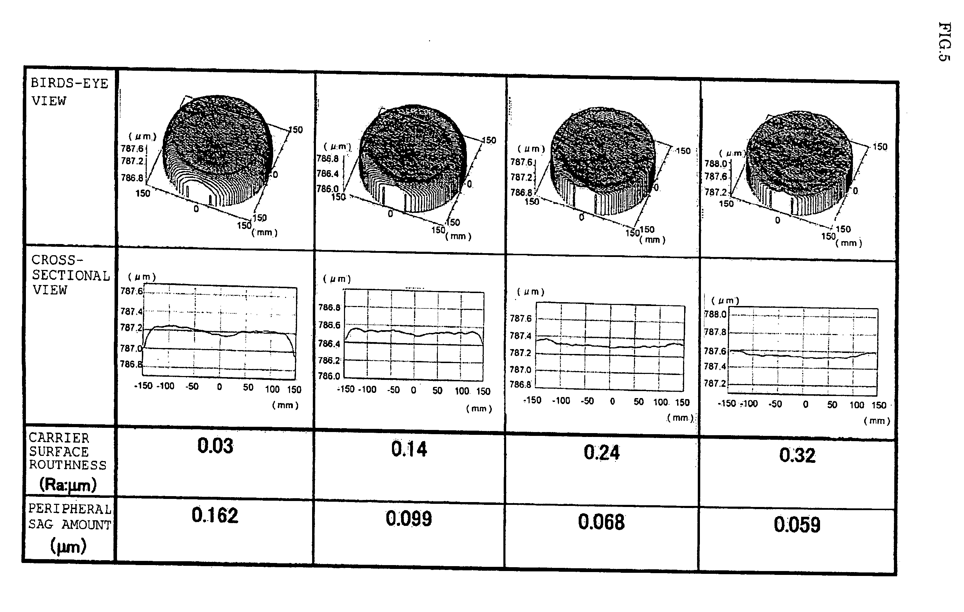

A peripheral sag amount of each polished wafer was measured. A wafer shape evaluation apparatus manufactured by Kuroda Precision Industries Ltd. was used to measure a difference in wafer shape between a position that is 1 mm away from a wafer edge and a position that is 3 mm away from the same as a peripheral sag amount with a section between a position that is 30 mm away from the wafer edge and a position where peripheral sag starts being determined as a reference plane as shown in FIG. 3. The following Table 1 and FIGS. 4 and 5 show measurement results.

**[Table 1]**

| Carrier surface roughness (Ra: µm) | Peripheral sag amount (µm) |
|---|---|
| 0.03 * | 0.162 |
| 0.08 * | 0.154 |
| 0.14 * | 0.099 |
| 0.24 * | 0.068 |
| 0.32 | 0.059 |
| 0.50 | 0.061 |

| | |
|---|---|
| * Comparative examples | |

As is obvious from Table 1 and FIGS. 4 and 5, it can be understood that setting roughness of each carrier surface to 0.14 µm or above in terms of Ra enables considerably improving the peripheral sag amount and obtaining each wafer having reduced peripheral sag and a high flatness. Further, it can be also understood that setting roughness of each carrier surface to 0.32 µm or above in terms of Ra according to the invention enables further reducing the peripheral sag.

It is to be noted that, in this experiment, deformation or damages of each carrier do not occur even if the front and back surfaces of the carrier are roughened, the carrier can be used to reach its life equivalent to that of a titanium carrier that is not subjected to processing of roughening the front and back surfaces of the carrier, and any difference in wafer quality other than a flatness from the non-processed carrier was not recognized.

However, when roughness of each carrier surface becomes too high, it can be considered that deformation or damages of the carrier are apt to occur and the life of the carrier is reduced. Therefore, it is desirable to set roughness of each surface to 10 µm or below in terms of Ra.

Additionally, it has been revealed that dressing of the polishing pads can be performed during polishing by roughening the front and back surfaces of the carrier. Although dressing is performed once in 10 batches in conventional examples, the same effect can be obtained by carrying out dressing once in 40 batches.

As explained above, the titanium carrier having surface roughness of 0.32 µm or above in terms of Ra has a long carrier life, and performing double-side polishing by using this carrier enables stably and efficiently producing a high-quality wafer having reduced metal contamination, decreased peripheral sag, and a high flatness at a low cost. Further, since dressing of the polishing pads can be performed by using carrier surfaces during polishing, a frequency of dressing of the polishing pads using, e.g., ceramic plate can be reduced, and an operating rate of the apparatus can be considerably improved.

Furthermore, it is preferable for the carrier according to the present invention to have grooves each reaching the holding hole from the carrier outer peripheral side on the front and back surfaces thereof. When the carrier has such grooves, since the polishing liquid is supplied to the semiconductor wafer through the grooves at the time of polishing, a resistance undergone by the wafer outer peripheral portion at the time of polishing can be alleviated, thereby reducing the peripheral sag. Further, since dressing of the polishing pads can be carried out by using the grooves during polishing, a frequency of dressing of the polishing pads using, e.g., ceramic plate can be further reduced.

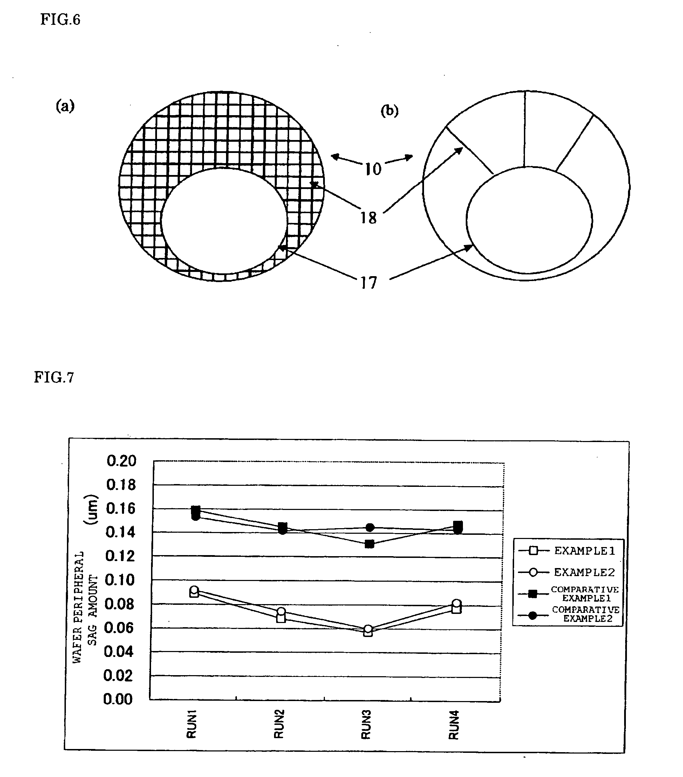

Although a pattern of the grooves is not restricted in particular, it may be, e.g., a grid-like pattern described in FIG. 6(a), a radial pattern grooves 18 shown in FIG. 6(b), or a pattern of horizontal stripes or vertical stripes.

Although a size of each groove 18 is not restricted in particular, the groove 18 may have, e.g., a width of 1 to 2 mm and a depth of 2 to 6 µm.

It is to be noted that the planetary carrier for the double-side polishing apparatus has been taken as an example and explained, the carrier for double-side polishing apparatus according to the present invention is not restricted to the planetary type, and it is also effective to adopt a carrier for swinging type double-side polishing apparatus.

When the double-side polishing apparatus 11 provided with the carrier 10 for the double-side polishing apparatus according to the present invention is adopted, a wafer having reduced metal contamination, decreased peripheral sag, and a high flatness can be obtained. Furthermore, since dressing of the polishing pads can be performed by using the carrier surfaces during polishing, a frequency of dressing of the polishing pads can be reduced, and an operating rate of the apparatus can be considerably improved. Moreover, since a carrier life is long, a cost can be reduced.

Additionally, the carrier 10 for the double-side polishing apparatus according to the present invention can be set between the upper and lower turn tables 12 and 13 having the polishing pads 14 of the double-side polishing apparatus 11 attached thereto, the semiconductor wafer W is held in the holding hole 17 to be sandwiched between the upper and lower turn tables 12 and 13, and the wafer W can be subjected to double-side polishing while supplying the polishing liquid.

When such a method is used to carry out double-side polishing, metal contamination can be suppressed, and a wafer having reduced peripheral sag and a high flatness can be stably obtained. Further, since dressing of the polishing pads can be carried out by using the carrier surfaces during polishing, a frequency of dressing of the polishing pads can be reduced, and polishing can be efficiently carried out. Furthermore, since each surface of the carried made of titanium itself has predetermined roughness, a coating layer of, e.g., abrasive grains can be prevented from being delaminated from each carrier surface to damage the wafer.

The present invention will be described in detail below based on examples and comparative examples. According to the invention, the surface roughness of the carrier is 0,32 µm or above in terms of Ra.

### (Examples 1 and 2)

A double-side polishing apparatus 11 shown in FIGS. 1 and 2 was prepared. Front and back surfaces of each titanium carrier 10 were roughened by using a diamond pellet in advance. Surface roughness of each carrier surface was measured by using Surf Test SJ-201P manufactured by Mitutoyo, and evaluation was carried out based on JIS B0601-1994. The surface roughness was Ra=0.28 to 0.32 µm (Examples 1 and 2). This carrier 10 was used to perform double-side polishing as follows.

After performing dressing of polishing pads 14, double-side polishing of each silicon wafer having a diameter of 300 mm was performed. That is, one etched silicon wafer W was set in each of five titanium carriers each having a holding hole 17, an upper turn table 13 was rotated in a clockwise direction whilst a lower turn table 12 was rotated in a counterclockwise direction with a number of revolutions of 20 rpm and a load of 250 g/cm², and an alkaline solution containing colloidal silica was used as a polishing liquid. This polishing was repeatedly performed for four times.

A peripheral sag amount of each wafer after polishing was measured. Like the above-explained experiment, a wafer shape evaluation apparatus manufactured by Kuroda Precision Industries Ltd. was used to measure a difference in wafer shape between a position that is 1 mm away from a wafer edge and a position that is 3 mm away from the same as a peripheral sag amount with a section from a position that is 30 mm apart form the wafer edge to a position where peripheral sag starts being determined as a reference plane. FIG. 7 shows obtained measurement results.

### (Comparative Examples 1 and 2)

Double-side polishing and measurement were carried out under the same conditions as those of (Examples 1 and 2) except that each titanium carrier (surface roughness was Ra=0.02 to 0.06 µm) having non-roughened front and back surfaces was used (Comparative Examples 1 and 2). FIG. 7 shows obtained measurement results.

As shown in FIG. 7, it has been confirmed that, when the front and back surfaces of each titanium carrier are roughened to have Ra of 0.14 µm or above, each wafer having reduced peripheral sag and a high flatness can be obtained in each of the four polishing operations.

### (Examples 3, 4, and 5)

Like Examples 1 and 2, front and back surfaces of each titanium carrier were roughened by using a diamond pellet (Ra=0.28 to 0.32 µm), and then grooves having such a grid-like pattern as described in FIG. 6(a) were formed. A groove width was 1 mm, a groove depth was 2 µm, and a groove interval was 2 mm. Double-side polishing was performed under the same conditions as those of Examples 1 and 2 except that each carrier having such grooves was used.

Further, a peripheral sag amount of each polished wafer was measured like Examples 1 and 2 (Examples 3, 4, and 5).

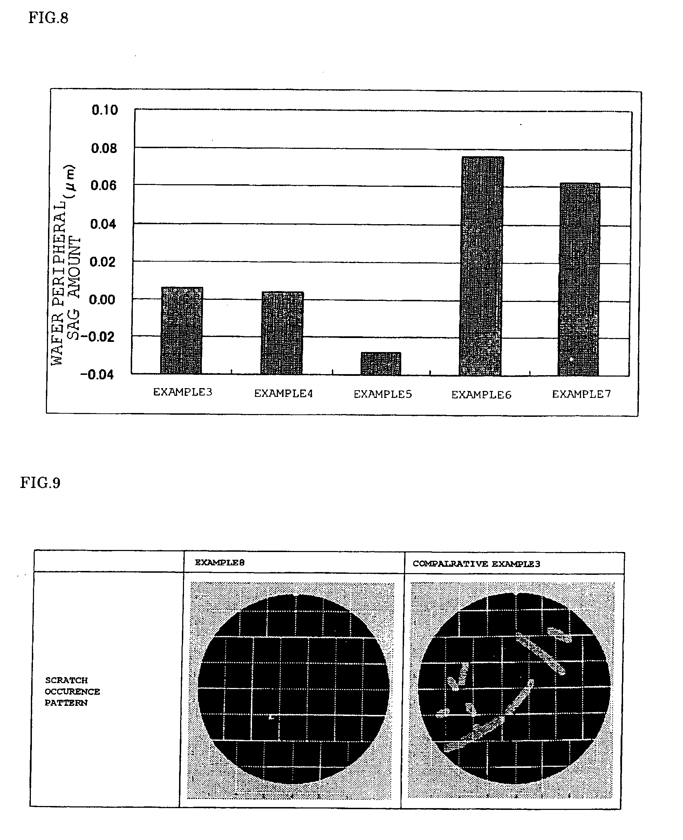

FIG. 8 shows obtained measurement results.

### (Examples 6 and 7)

Double-side polishing and measurement were performed under the same conditions as those of (Examples 3, 4, and 5) except that each titanium carrier having no groove formed thereon and Ra=0.28 to 0.32 µm was used (Examples 6 and 7). FIG. 8 shows obtained measurement results.

It can be understood from the measurement results of the peripheral sag amount described in FIG. 8 that each wafer according to Examples 3, 4, and 5 has a higher flatness than each wafer according to Examples 6 and 7. In particular, it has been confirmed that the peripheral sag amount according to each of Examples 3, 4, and 5 is far smaller than that according to Examples 6 and 7 and the peripheral sag can be further improved by forming the grooves on the carrier.

### (Example 8)

Double-side polishing was performed under the same conditions as those of Examples 1 and 2. Surface roughness of each carrier having front and back surfaces roughened by a diamond pellet was Ra=0.28 to 0.32 µm.

Observing each polished wafer by using a wafer surface inspection apparatus manufactured by Raytex Corporation, no scratch was observed on each wafer surface (FIG. 9), and it has been confirmed that the high-quality wafer was obtained.

### (Comparative Example 3)

Each surface of SUS carrier was subjected to blast processing to form an uneven surface having surface roughness Ra=4.8 to 5.0µm. Ceramic abrasive grains were deposited on this uneven surface. Double-side polishing was carried out under the same conditions as those of Example 8 except that such carrier was used.

Observing each polished wafer by using the wafer surface inspection apparatus manufactured by Raytex Corporation, scratches were observed on the wafer surface (FIG. 9). It can be considered that the abrasive grains deposited on the carrier surfaces fell off to occur scratches on the wafer surface during polishing.

When the carrier having abrasive grains deposited thereon is used in this manner, a quality of a wafer may be possibly degraded, but using the carrier according to the present invention enables obtaining a high-quality wafer.

## Claims

1. A carrier (10) for double-side polishing apparatus (11) which is set between upper and lower turn tables (13; 12) having polishing pads (14) attached thereto and has a holding hole (17) in which a semiconductor wafer sandwiched between the upper and lower turn tables (13; 12) is held at the time of polishing in a double-side polishing apparatus (11), **characterised in that** the material of the carrier (10) is titanium, and surface roughness of the titanium carrier (10) is 0.32 µm or above in terms of Ra.

2. The carrier (10) for double-side polishing apparatus (11) according to claim 1, wherein the carrier (10) has grooves (18) each reaching the holding hole (17) from a carrier outer peripheral side on front and back surfaces thereof.

3. The carrier (10) for double-side polishing apparatus (11) according to claim 2, wherein a pattern of the grooves (18) is a grid-like pattern or a radial pattern.

4. A double-side polishing apparatus (11) comprising at least the carrier (10) for double-side polishing apparatus (11) according to any one of claims 1 to 3.

5. A double-side polishing method for a semiconductor wafer, comprising: arranging the carrier (10) according to any one of claims 1 to 3 between upper and lower turn tables (13; 12) holding the semiconductor wafer in a holding hole (17) formed in the carrier (10); and sandwiching the semiconductor wafer between the upper and lower turn tables (13; 12) to perform double-side polishing.

## Patentansprüche

1. Träger (10) für doppelseitige Poliervorrichtung (11) die zwischen obere und untere Drehplatten (13; 12) mit daran angefügten Polierblöcken (14) angeordnet ist und eine Halteöffnung (17) aufweist, in die ein zwischen die obere und untere Drehplatten (13; 12) eingelegter Halbleiter-Wafer während der Polierzeit in einer doppelseitigen Poliervorrichtung (11) gehalten wird, **dadurch gekennzeichnet, dass** das Material des Trägers (10) Titan ist und die Oberflächenrauhigkeit des Titanträgers (10) bezogen auf Ra 0,32 µm oder höher ist.

2. Träger (10) für doppelseitige Poliervorrichtung (11) nach Anspruch 1, wobei der Träger (10) Rillen (18) aufweist, die jede die Halteöffnung (17) von einer äußeren Peripherie-Seite des Trägers auf vorderen und hinteren Oberflächen davon erreicht.

3. Träger (10) für doppelseitige Poliervorrichtung (11) nach Anspruch 2, wobei ein Muster der Rillen (18) ein rasterartiges Muster oder ein radiales Muster ist.

4. Doppelseitige Poliervorrichtung (11) umfassend mindestens den Träger (10) für doppelseitige Poliervorrichtung (11) gemäß einem beliebigen der Ansprüche 1 bis 3.

5. Verfahren zum doppelseitigen Polieren eines Halbleiter-Wafers, umfassend: anordnen des Trägers (10) gemäß einem beliebigen der Ansprüche 1 bis 3 zwischen obere und untere Drehplatten (13; 12) die den Halbleiter-Wafer in einer in dem Träger (10) gebildeten Halteöffnung (17) halten; und einlegen des Halbleiterwafers zwischen die oberen und unteren Drehplatten (13; 12) um doppelseitiges Polieren durchzuführen.

## Revendications

1. Support (10) pour appareil (11) de polissage double face qui est fixé entre des tables rotatives supérieure et inférieure (13 ; 12) ayant des tampons (14) de polissage fixés à celles-ci et a un trou (17) de maintien dans lequel une tranche de semi-conducteur prise en sandwich entre les tables rotatives supérieure et inférieure (13 ; 12) est maintenue au moment du polissage dans un appareil (11) de polissage double face, **caractérisé en ce que** le matériau du support (10) est le titane, et une rugosité de surface du support (10) en titane est 0,32 µm ou plus en termes de Ra.

2. Support (10) pour appareil (11) de polissage double face selon la revendication 1, dans lequel le support (10) a des rainures (18) atteignant chacune le trou (17) de maintien à partir d'un côté périphérique extérieur de support sur des surfaces avant et arrière de celui-ci.

3. Support (10) pour appareil (11) de polissage double face selon la revendication 2, dans lequel un motif des rainures (18) est un motif de type grille ou un motif radial.

4. Appareil (11) de polissage double face comprenant au moins le support (10) pour appareil (11) de polissage double face selon l'une quelconque des revendications 1 à 3.

5. Procédé de polissage double face pour une tranche de semi-conducteur, comprenant : l'agencement du support (10) selon l'une quelconque des revendications 1 à 3 entre des tables rotatives supérieure et inférieure (13 ; 12) maintenant la tranche de semi-conducteur dans un trou (17) de maintien formé dans le support (10) ; et la prise en sandwich de la tranche de semi-conducteur entre les tables rotatives supérieure et inférieure (13 ; 12) pour exécuter le polissage double face.
